# FASCICULE DE BREVET EUROPEEN

(11) **EP 3 591 475 B1**
(45) Date de publication et mention de la délivrance du brevet: **24.02.2021**
(21) Numéro de dépôt: 18181271.0
(22) Date de dépôt: 02.07.2018
(51) Int. Cl.: G04C 10/00, G04G 19/00

(54) **MONTRE THERMOELECTRIQUE TESTABLE EN PRODUCTION OU SERVICE APRES-VENTE**
THERMOELEKTRISCHE ARMBANDUHR, DIE BEI DER PRODUKTION ODER IM RAHMEN DES KUNDENDIENSTES GETESTET WERDEN KANN
THERMOELECTRIC WATCH SUITABLE FOR BEING TESTED IN PRODUCTION OR AFTER-SALES SERVICE

(43) Date de publication de la demande: 08.01.2020
(73) Titulaire: The Swatch Group Research and Development Ltd, 2074 Marin (CH)
(72) Inventeur: Gueissaz, François, 2036 Cormondrèche (CH); Jornod, Alain, 2000 Neuchâtel (CH); Theoduloz, Yves, 1400 Yverdon (CH)
(74) Mandataire: ICB SA

(56) Documents cités:
- EP-A1- 3 339 981
- EP-A2- 0 933 863
- EP-A2- 0 935 178

## Description

### Domaine technique

L'invention se rapporte à une montre thermoélectrique comprenant un générateur thermoélectrique, un élévateur de tension connecté audit générateur thermoélectrique et un circuit de gestion d'énergie connecté audit élévateur de tension et configuré pour gérer la charge d'au moins un élément de stockage d'énergie.

### Arrière-plan technologique

Dans le domaine des montres thermoélectriques (EP 3 339 981 A1, EP 0 935 178 A2, EP 0 933 863 A2), il est connu de l'homme du métier d'utiliser un générateur thermoélectrique qui permet, à partir de la chaleur du corps, de fournir de l'énergie électrique à une montre lorsque cette dernière se trouve sur le poignet. Le générateur thermoélectrique produisant une faible tension, un élévateur de tension permet d'augmenter la tension produite de sorte à obtenir une tension suffisamment grande pour alimenter un circuit de gestion d'énergie. Le circuit de gestion d'énergie permet de charger au moins un élément de stockage tel qu'une batterie de sorte à alimenter un moteur de la montre thermoélectrique même lorsque les conditions de génération d'énergie thermoélectrique ne sont plus remplies.

Un inconvénient est qu'en production ou en service après-vente, un opérateur ne peut pas savoir si la génération thermoélectrique est active ou inactive.

### Résumé de l'invention

Le but de la présente invention est de pallier l'inconvénient cité précédemment.

A cet effet, selon un premier aspect, l'invention se rapporte à une montre thermoélectrique selon la revendication 1.

Ainsi, comme nous allons le voir en détail par la suite, lorsque la sortie de gestion d'énergie passe d'un état à un autre état (via une transition montante ou descendante), il est possible, par différents couplages (optique, acoustique, capacitif, inductif, radiofréquence) entre la charge et un appareil de test, de savoir quand la génération thermoélectrique est activée ou désactivée.

Conformément à des modes de réalisation non limitatifs de l'invention, la montre thermoélectrique peut présenter les caractéristiques des revendications 2 à 10, prises seules ou selon toutes les combinaisons techniquement possibles.

Selon un deuxième aspect, l'invention se rapporte à une montre thermoélectrique selon la revendication 11.

Ainsi, comme nous allons le voir en détail par la suite, lorsque la sortie de gestion d'énergie passe d'un état à un autre état (via une transition montante ou descendante), il est possible, par détection du potentiel électrique de l'élément conducteur au moyen d'un appareil de test, de savoir quand le condensateur se charge et ainsi quand la génération thermoélectrique est activée ou désactivée.

Conformément à des modes de réalisation non limitatifs de l'invention, la montre thermoélectrique peut présenter les caractéristiques des revendications 12 à 14, prises seules ou selon toutes les combinaisons techniquement possibles.

### Brève description des figures

L'invention sera décrite ci-après de manière plus détaillée à l'aide des dessins annexés, donnés à titre d'exemples nullement limitatifs, dans lesquels :
- La figure 1 représente schématiquement une montre thermoélectrique selon un premier mode de réalisation non limitatif de l'invention, ladite montre thermoélectrique comprenant un générateur de tension, un élévateur de tension, et un circuit de gestion d'énergie,
- La figure 2a représente le circuit de gestion d'énergie de la figure 1 connecté avec un unique condensateur, lui-même couplé à une charge, selon le premier mode de réalisation,
- La figure 2b représente le circuit de gestion d'énergie de la figure 1 connecté avec deux condensateurs, chacun couplé à une charge, selon un deuxième mode de réalisation non limitatif de l'invention,
- La figure 3a représente le circuit de gestion d'énergie et le condensateur de la figure 2a, ledit condensateur étant couplé à une charge qui est une diode électroluminescente émettant dans le spectre infrarouge, selon une première variante de réalisation non limitative du premier mode de réalisation,
- La figure 3b représente un appareil de mesure configuré pour mesurer un signal infrarouge émis par ladite diode électroluminescente de la figure 3a, à l'aide d'un photo-détecteur,
- La figure 3c représente le circuit de gestion d'énergie et les deux condensateurs de la figure 2b, lesdits condensateurs étant chacun couplé à une charge qui est une diode électroluminescente émettant dans le spectre infrarouge, selon une première variante de réalisation non limitative du deuxième mode de réalisation,
- La figure 4a représente le circuit de gestion d'énergie et le condensateur de la figure 2a, ledit condensateur étant couplé à une charge qui est un circuit oscillant, selon une deuxième variante de réalisation non limitative du premier mode de réalisation,
- La figure 4b représente un appareil de mesure configuré pour mesurer un signal radiofréquence émis par ledit circuit oscillant de la figure 4a,
- La figure 4c représente le circuit de gestion d'énergie et les deux condensateurs de la figure 2b, lesdits condensateurs étant chacun couplé à une charge qui est un circuit oscillant, selon une deuxième variante de réalisation non limitative du deuxième mode de réalisation,
- La figure 5a représente le circuit de gestion d'énergie et le condensateur de la figure 2a, ledit condensateur étant couplé à une charge qui est un transducteur électromécanique, selon une troisième variante de réalisation non limitative du premier mode de réalisation,
- La figure 5b représente un appareil de mesure configuré pour mesurer un signal acoustique émise par ledit transducteur électromécanique de la figure 5a,
- La figure 5c représente le circuit de gestion d'énergie et les deux condensateurs de la figure 2b, lesdits condensateurs étant chacun couplé à une charge qui est un transducteur électromécanique, selon une troisième variante de réalisation non limitative du deuxième mode de réalisation,
- La figure 6a représente le circuit de gestion d'énergie et le condensateur de la figure 2a, ledit condensateur étant couplé à une charge qui est une inductance, selon une quatrième variante de réalisation non limitative du premier mode de réalisation,
- La figure 6b représente un appareil de mesure configuré pour mesurer un signal électromagnétique émis par ladite inductance de la figure 6a,
- La figure 7 représente schématiquement une montre thermoélectrique selon un deuxième mode de réalisation de l'invention, ladite montre thermoélectrique comprenant un générateur de tension, un élévateur de tension, et un circuit de gestion d'énergie selon un troisième mode de réalisation non limitatif de l'invention,
- La figure 8 représente le circuit de gestion d'énergie de la figure 7 connecté avec un condensateur, lui-même connecté à un élément conducteur.

### Description détaillée de l'invention

Les éléments identiques, par structure ou par fonction, apparaissant sur différentes figures conservent, sauf précision contraire, les mêmes références.

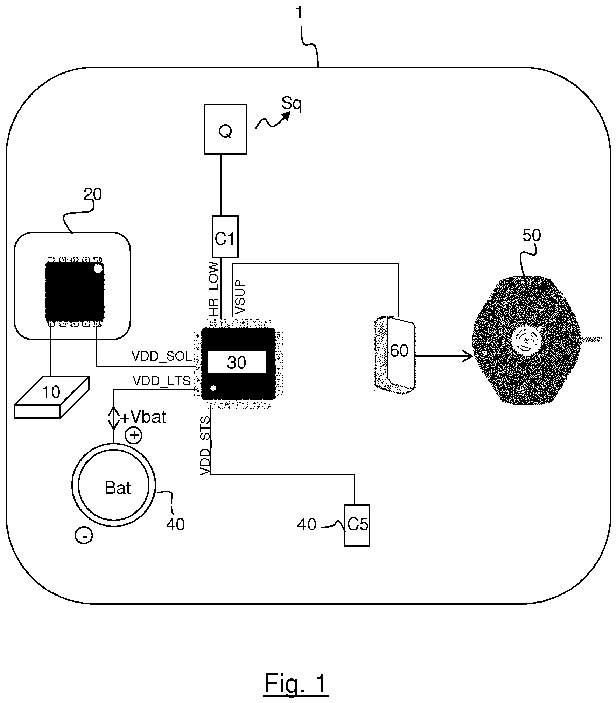

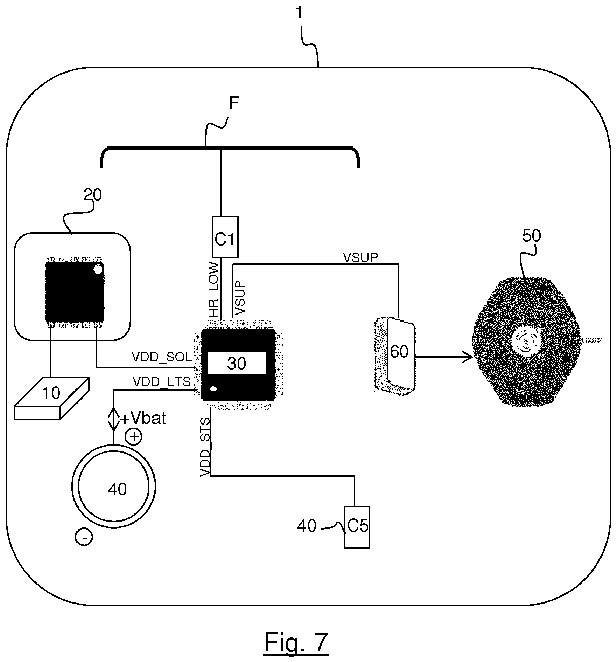

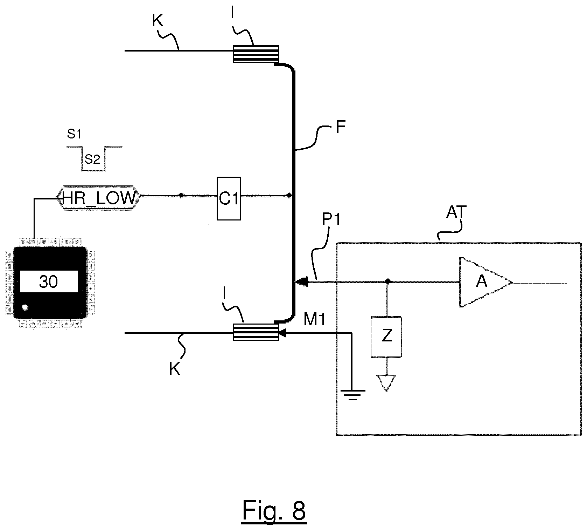

La montre thermoélectrique 1 est décrite selon un premier et un deuxième mode de réalisation non limitatifs illustrés sur les figures 1 à 6b, puis selon un troisième mode de réalisation non limitatif illustré sur les figures 7 et 8.

### • Premier et deuxième modes de réalisation non limitatifs

Telle qu'illustrée sur la figure 1, la montre thermoélectrique 1 comprend :
- un générateur thermoélectrique 10 ;
- un élévateur de tension 20 ;
- un circuit de gestion d'énergie 30 ;
- au moins un condensateur C1.

La montre thermoélectrique 1 comprend un outre :
- un élément de stockage d'énergie 40 ;
- un moteur 50 configuré pour mettre en mouvement les aiguilles et cadran(s) (non illustrés) de la montre thermoélectrique 1 ;
- un résonateur 60 configuré pour servir de base de fréquence pour la montre thermoélectrique 1.

Dans la suite de la description, la montre thermoélectrique 1 est également appelée montre 1. Les éléments de la montre 1 sont décrits en détail ci-après.

### ∘ Générateur thermoélectrique 10

Le générateur thermoélectrique 10 est configuré pour produire une énergie électrique, à savoir une tension faible, de l'ordre de quelques millivolts (mV) à partir de la chaleur du corps humain lorsque la montre 1 se trouve sur le poignet d'un utilisateur. Dans un exemple non limitatif, la tension est comprise entre 6 et 12mV. On notera que la génération de l'énergie électrique prend normalement moins d'une seconde lorsque la montre 1 est mise sur le poignet.

Ainsi, le générateur thermoélectrique 10 devient actif lorsque la montre est portée sur le poignet. Le générateur thermoélectrique 10 permet de démarrer la montre 1 lorsque la batterie de cette dernière est déchargée.

Les générateurs thermoélectriques étant connus de l'homme du métier, le générateur thermoélectrique 10 n'est pas décrit en détail ici.

Le générateur thermoélectrique 10 est connecté à l'élévateur de tension 20.

### ∘ Elévateur de tension 20

L'élévateur de tension 20 est configuré pour augmenter la tension générée par le générateur thermoélectrique 10 de sorte à obtenir une tension suffisamment grande pour alimenter le circuit de gestion d'énergie 30. Cette tension est de l'ordre du Volt. Dans un exemple non limitatif, elle est égale à 2,5V.

L'élévateur de tension 20 est connecté au circuit de gestion d'énergie 30.

La tension générée se retrouve sur une entrée VDD_SOL dudit circuit de gestion d'énergie 30. Ainsi, une tension supérieure ou égale à un seuil (2,5V dans l'exemple non limitatif décrit), signifie que le générateur thermoélectrique 10 est devenu actif, en d'autres termes qu'il a débuté une génération d'énergie électrique.

Les élévateurs de tension étant connus de l'homme du métier, l'élévateur de tension 20 n'est pas décrit en détail ici.

### ∘ Circuit de gestion d'énergie 30 et élément de stockage d'énergie 40

Le circuit de gestion d'énergie 30 est configuré pour gérer la charge d'au moins un élément de stockage d'énergie 40.

Dans un mode de réalisation non limitatif, le circuit de gestion d'énergie 30 est un microcontrôleur programmable configuré pour réaliser la charge dudit au moins un élément de stockage d'énergie 40.

Dans un mode de réalisation non limitatif, le circuit de gestion 30 comporte un étage amplificateur push-pull de sorte à obtenir des transitions montantes et descendantes sur la sortie HR_LOW décrite ci-après, avec une certaine capacité à délivrer du courant, typiquement 1 à 2 mA dans un mode de réalisation non limitatif.

Tel qu'illustré sur la figure 1, le circuit de gestion d'énergie 30 comprend notamment :
- une entrée VDD_SOL,
- une sortie HR_LOW,
- une sortie VSUP,
- une sortie VDD_LTS,
- une sortie VDD_STS.

Grâce à la tension reçue sur son entrée VDD_SOL, le circuit de gestion d'énergie 30 peut alimenter ledit au moins un élément de stockage d'énergie 40.

Dans un exemple non limitatif, ledit au moins un élément de stockage d'énergie 40 est une batterie Bat. La batterie Bat permet d'alimenter par exemple le moteur 50 de la montre 1 même lorsqu'il n'y a plus de génération d'énergie thermoélectrique.

Dans un mode de réalisation non limitatif, le circuit de gestion d'énergie 30 est configuré pour gérer la charge de deux éléments de stockage d'énergie 40. Chaque élément de stockage d'énergie 40 est connecté au circuit de gestion d'énergie 30 via les sorties respectives VDD_LTS et VDD_STS.

Dans un mode de réalisation non limitatif, un premier élément de stockage d'énergie 40 est un élément de stockage d'énergie à court terme (« Short Term Storage » en anglais) et un deuxième élément de stockage d'énergie 40 est un élément de stockage d'énergie à long terme (« Long Term Storage » en anglais). Dans un exemple non limitatif, l'élément de stockage d'énergie à court terme est un condensateur référencé C5 sur la figure 1, et l'élément de stockage d'énergie à long terme est une batterie rechargeable référencée Bat sur la figure 1. Dans un exemple non limitatif, la batterie Bat est une batterie Lithium-Ion.

Le condensateur C5 et la batterie Bat sont pris comme exemples non limitatifs dans la suite de la description.

Dans un mode de réalisation non limitatif, ledit circuit de gestion d'énergie 30 est configuré pour gérer alternativement la charge du condensateur C5 et de la batterie Bat de sorte à alimenter par exemple le moteur 50 de ladite montre 1. A cet effet, il comprend en outre une pluralité de commutateurs (non illustrés).

Ainsi, le circuit de gestion d'énergie 30 commence par charger, via son entrée VDD_SOL, le condensateur C5 qui se charge en quelques secondes (entre 3 à 5 secondes typiquement selon l'expérience produit visée). Puis, lorsque ce dernier est chargé (il a atteint une tension suffisante, entre 1,5V et 3V par exemple), le circuit de gestion d'énergie 30 déconnecte le condensateur C5 de son entrée VDD_SOL et il charge via son entrée VDD_SOL la batterie Bat qui se charge plus lentement en quelques heures voire quelques jours, jusqu'à atteindre une tension suffisante, entre 1,5V et 3V par exemple.

Pendant que la batterie Bat se charge, le condensateur C5 se décharge au niveau de la sortie VSUP, ce qui permet d'alimenter le moteur 50 de la montre 1 et ainsi démarrer le mouvement de la montre 1. Le condensateur C5 se décharge en effet en quelques secondes.

La batterie Bat permet de prendre le relais du condensateur C5 pour alimenter le moteur 50. La batterie Bat se décharge également sur la sortie VSUP ce qui permet d'alimenter le moteur 50 de la montre 1 pendant quelques mois. La batterie Bat peut en effet mettre quelques mois à se décharger.

Lorsque le condensateur C5 et la batterie Bat ont atteint chacun une tension suffisante respective, le circuit de gestion d'énergie 30 connecte les deux en parallèle.

Ainsi, lorsque le générateur thermoélectrique 10 est actif, l'énergie électrique générée par le générateur thermoélectrique 10 arrive sur l'entrée VDD_SOL, ce qui permet de charger le condensateur C5 et la batterie Bat.

Lorsque le générateur thermoélectrique 10 est inactif, à savoir il ne génère plus d'énergie électrique, le condensateur C5 et la batterie Bat sont déconnectés de l'entrée VDD_SOL.

Le générateur thermoélectrique 10 devient inactif lorsque par exemple la montre 1 est à l'équilibre thermique et n'est plus portée sur le poignet. Lorsqu'elle est de nouveau mise sur le poignet, la gestion alternée de la charge du condensateur C1 et de la batterie Bat décrite précédemment reprend.

La sortie HR_LOW du circuit de gestion d'énergie 30 est configurée pour :
- passer d'un premier état logique S1 à un deuxième état logique S2 lorsque le générateur thermoélectrique 10 débute une génération d'énergie électrique, et
- passer du deuxième état logique S2 au premier état logique S1 lorsque ledit générateur thermoélectrique 10 achève la génération d'énergie électrique.

La sortie HR_LOW permet ainsi de signaler l'activité du générateur thermoélectrique 10.

Dans la suite, on conviendra que le premier état logique S1 est un état haut, et le deuxième état S2 est un état bas. Toutefois, cela pourrait être l'inverse.

Dans un mode de réalisation non limitatif, l'état haut S1 est au potentiel +Vbat et l'état bas S2 est au potentiel -Vbat.

Ainsi, la sortie HR_LOW est en transition montante lorsqu'elle passe de l'état bas S2 à l'état haut S1 et est en transition descendante lorsqu'elle passe de l'état haut S1 à l'état bas S2.

Plus particulièrement, la sortie HR_LOW est configurée pour :
- passer de l'état haut S1 à l'état bas S2 lorsque ledit générateur thermoélectrique 10 débute une génération d'énergie électrique ;
- passer de l'état bas S2 à l'état haut S1 lorsque ledit générateur thermoélectrique 10 achève une génération d'énergie électrique.

L'état bas de la sortie HR_LOW signifie que le générateur thermoélectrique 10 est actif. L'état haut de la sortie HR_LOW signifie que le générateur thermoélectrique 10 est inactif.

On estime que, au cours d'une utilisation normale, la sortie HR_LOW ne peut pas avoir plus d'une centaine de transitions montantes et/ou descendantes par jour. Une centaine de transitions par jour correspond à un courant moyen inférieur à 0,1 microampères au travers du condensateur C1 cité plus bas, ce qui représente un faible pourcentage de consommation de la montre 1, inférieur à 10 %.

Le circuit de gestion d'énergie 30 est connecté audit au moins un condensateur C1 décrit ci-après.

### ∘ Condensateur C1

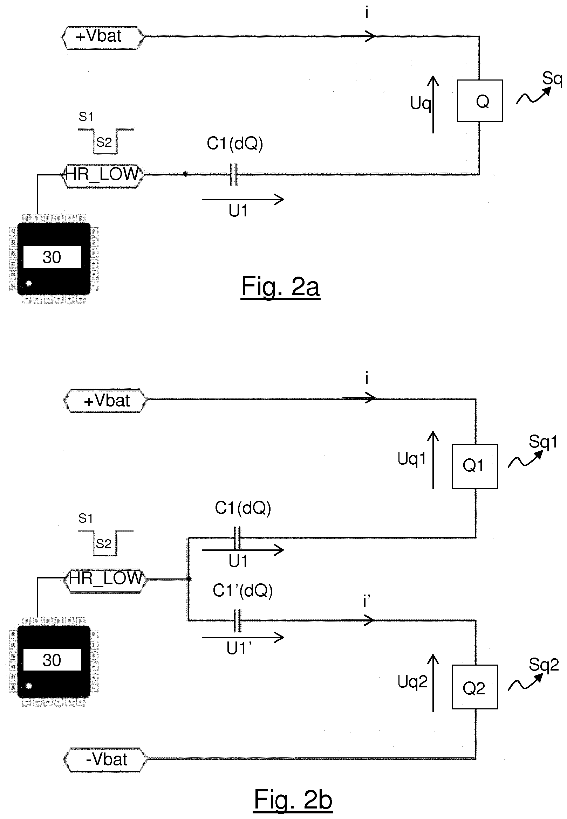

Tel qu'illustré sur les figures 1, 2a et 2b, ledit au moins un condensateur C1 est couplé à une charge Q, et est configuré pour :
- subir une variation de charge dQ lorsque ladite sortie HR_LOW dudit circuit de gestion d'énergie 30 passe d'un état S1, S2 à un autre état S2, S1,
- alimenter en courant ladite charge Q lorsqu'il subit ladite variation de charge dQ.

Le courant qui alimente la charge Q est égal à dQ/dt. La charge d'un condensateur étant exprimée par Q=C*U, on a Q1=C1*Vbat au maximum dans l'exemple non limitatif pris, et dQ = + ou - Q1.

Le condensateur C1 est connecté en série avec ladite charge Q.

Ainsi, le condensateur C1 est connecté à une de ses bornes au circuit de gestion d'énergie 30 et à l'autre de ses bornes à la charge Q.

Lorsque le condensateur C1 subit une variation de charge dQ, le courant de charge ou décharge, autrement appelé courant i, nécessaire à sa charge ou décharge, circule de façon transitoire dans la charge Q lui permettant d'émettre un signal Sq détectable par un appareil de mesure AT.

On notera qu'après une transition montante ou descendante de la sortie HR_LOW, lorsque ladite sortie HR_LOW reste dans un des deux états S1, S2, il n'y a aucun courant i qui circule dans la charge Q. Ainsi, la charge Q ne consomme pas en régime stationnaire mais uniquement pendant les transitions montante et descendante. Son potentiel moyen est Uq=0.

Le courant i qui parcourt la charge Q est en fait une impulsion de courant puisqu'il est produit uniquement lorsque le condensateur C1 subit une variation de charge dQ, à savoir lors des transitions montante ou descendante de la sortie HR_LOW. L'intensité de cette impulsion de courant est de l'ordre du milliampère. Dans un exemple non limitatif, elle est comprise entre 1 et 10 mA. On notera que l'intensité des impulsions de courant tombe typiquement à 10 % après une durée de moins de 50 millisecondes. Ainsi, le signal Sq émis par la charge Q ne dure pas longtemps, pendant une durée typiquement inférieure à 50 millisecondes.

### ▪ Premier mode de réalisation

Dans un premier mode de réalisation non limitatif illustré sur la figure 2a, ledit circuit de gestion d'énergie 30 est connecté à un unique circuit de transmission, formé par un condensateur C1 et une charge Q.

Ledit condensateur C1 est couplé à la charge Q, elle-même connectée à +Vbat dans cet exemple, et est configuré pour :
- se charger lorsque ladite sortie HR_LOW dudit circuit de gestion d'énergie 30 passe de l'état haut S1 à l'état bas S2, à savoir lorsque ladite sortie HR_LOW est en transition descendante ; et/ou
- se décharger lorsque ladite sortie HR_LOW dudit circuit de gestion d'énergie 30 passe de l'état bas S2 à l'état haut S1, à savoir lorsque ladite sortie HR_LOW est en transition montante.

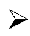 Transition descendante

La charge du condensateur C1 lors de la transition descendante de la sortie HR_LOW correspond au début d'une génération d'énergie électrique par le générateur thermoélectrique 10. Le courant i nécessaire pour la charge du condensateur C1 passe par la charge Q qui émet alors un signal Sq.

Le changement d'état de la sortie HR_LOW cause ainsi l'émission d'un signal Sq par la charge Q.

Ainsi, lorsque le générateur thermoélectrique 10 débute une génération d'énergie (il devient actif), la charge Q émet un signal Sq qui est détectable par un appareil de mesure AT. L'utilisateur voit ainsi, via l'appareil de mesure AT, que le générateur thermoélectrique 10 vient de démarrer, à savoir il vient de débuter la génération d'énergie électrique. On notera que l'utilisateur est dans un exemple non limitatif, un opérateur qui teste la montre 1 en production ou en service après-vente.

Dans une variante de l'exemple cité non limitatif, le générateur thermoélectrique 10 devient actif lorsque la montre 1 est mise sur le poignet de l'utilisateur. La montre 1 vient en effet en contact avec la chaleur du corps humain.

Après la transition descendante, lorsque la sortie HR_LOW reste à l'état bas S2 (le générateur thermoélectrique 10 est toujours actif), la valeur du courant i qui circule dans la charge Q tombe rapidement à zéro. Par conséquent l'appareil de mesure AT ne détecte plus de signal Sq.

On notera, dans l'exemple cité, que le signal Sq émis est détectable par l'appareil de mesure AT quelques secondes après que la montre thermoélectrique 1 a été placée au poignet ou sur un posage adéquat, une fois que l'élément de stockage d'énergie à court terme C5 s'est chargé avec l'énergie électrique produite par le générateur thermoélectrique 10.

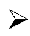 Transition montante

Dans l'exemple cité et sa variante, la décharge du condensateur C1 lors de la transition montante de la sortie HR_LOW correspond à une interruption de la génération d'énergie électrique par le générateur thermoélectrique 10. Le courant i nécessaire pour la décharge du condensateur C1 passe par la charge Q qui émet alors ou n'émet pas de signal Sq, selon si elle est configurée ou non pour émettre un signal dans les deux polarités de courant.

Dans le cas où la charge Q permet de générer un signal Sq dans les deux polarités de courant, une transition montante de la sortie HR_LOW cause également l'émission d'un signal Sq. Ainsi, lorsque le générateur thermoélectrique 10 achève une génération d'énergie (il devient inactif), la charge Q peut également émettre un signal Sq qui est détectable par un appareil de mesure AT. L'utilisateur voit ainsi, via l'appareil de mesure AT, que le générateur thermoélectrique 10 vient d'arrêter de fonctionner, à savoir il a achevé la génération d'énergie électrique. On notera que l'utilisateur est dans un exemple non limitatif, un opérateur qui teste la montre 1 en production ou en service après-vente.

Dans un exemple non limitatif, le générateur thermoélectrique 10 devient inactif lorsque la montre 1 n'est plus portée sur le poignet de l'utilisateur. La montre 1 n'est en effet plus en contact avec la chaleur du corps humain et tend ainsi vers l'équilibre thermique aux bornes du générateur thermoélectrique.

Dans un autre exemple non limitatif, le générateur thermoélectrique 10 devient inactif lorsque la montre 1 se trouve en plein soleil avec un cadran foncé qui absorbe l'énergie du soleil. Même si elle reste sur le poignet, la carrure de la montre 1 devient plus chaude que le poignet. Le générateur thermoélectrique 10 peut s'arrêter plusieurs fois dans la journée.

On estime que, au cours d'une utilisation normale, le générateur thermoélectrique 10 peut s'arrêter et redevenir actif au maximum une centaine de fois par jour.

Après la transition montante, lorsque la sortie HR_LOW reste à l'état haut S1 (le générateur thermoélectrique 10 est toujours inactif), la valeur du courant i qui circule dans la charge Q tombe rapidement à zéro. Par conséquent l'appareil de mesure AT ne détecte plus de signal Sq.

On notera que le signal émis Sq, détectable par l'appareil de mesure AT, apparaît au bout de quelques secondes à quelques minutes, selon les conditions thermiques, après que la montre 1 a été retirée du poignet, durée qui correspond au temps que met le fond de la montre 1 qui a été réchauffé par la chaleur du corps humain à se refroidir.

On notera que la figure 2a illustre la charge Q connectée à la borne positive +Vbat de la batterie Bat. Toutefois, dans un autre mode de réalisation non limitatif non illustré, la charge Q pourrait être connectée à la borne négative -Vbat de la batterie Bat ou tout autre potentiel statique.

Ainsi, l'impulsion électrique négative ou positive observée sur le potentiel Uq de la charge Q est le reflet des transitions descendante ou montante de la sortie HR_LOW du circuit de gestion d'énergie 30. En fonction de cette impulsion électrique positive ou négative, la charge Q émet le signal Sq selon si elle a été conçue pour une action unipolaire ou bipolaire. Ainsi, l'appareil de mesure AT peut détecter les transitions montante et descendante de ladite sortie HR_LOW au travers du signal Sq émis et par conséquent peut détecter le début ou l'achèvement de la génération d'énergie électrique du générateur thermoélectrique 10.

### ▪ Deuxième mode de réalisation

Dans un deuxième mode de réalisation non limitatif illustré sur la figure 2b, ledit circuit de gestion d'énergie 30 est connecté à deux circuits distincts de transmissions, chacun formé par un condensateur C1, C1' couplé à une charge Q1, Q2.

L'un des condensateurs est configuré pour subir une variation de charge dQ lorsque ladite sortie HR_LOW passe de l'état haut S1 à l'état bas S2, et l'autre des condensateurs est configuré pour subir une variation de charge dQ lorsque ladite sortie HR_LOW passe de l'état bas S2 à l'état haut S1.

Ainsi, dans une variante de réalisation non limitative, le condensateur C1 est configuré pour :
- se charger lorsque ladite sortie HR_LOW passe de l'état haut S1 à l'état bas S2, et
- alimenter en courant la charge Q1 à laquelle il est couplé lorsqu'il se charge, ladite charge Q1 étant configurée pour émettre un signal Sq détectable par un appareil de mesure AT lorsqu'elle est parcourue par le courant de charge i dudit condensateur C1,
Par ailleurs, le condensateur C1' est configuré pour :
- se décharger lorsque ladite sortie HR_LOW passe de l'état bas S2 à l'état haut S1, et
- alimenter en courant la charge Q2 à laquelle il est couplé lorsqu'il se décharge, ladite charge Q2 étant configurée pour émettre un signal Sq' détectable par l'appareil de mesure AT lorsqu'elle est parcourue par le courant de décharge i' dudit condensateur C1'.

Ainsi, le courant de charge i nécessaire pour charger le condensateur C1 circule dans la charge Q1, et le courant de décharge i' nécessaire pour charger le condensateur C1' circule dans la charge Q2.

Ainsi, la charge Q1 émet un signal Sq1 lorsque le générateur thermoélectrique 10 débute une génération d'énergie électrique et la charge Q2 émet un signal Sq2 lorsque le générateur thermoélectrique 10 achève une génération d'énergie électrique.

Dans un mode de réalisation non limitatif, la charge Q1 est connectée à la borne positive de la batterie +Vbat et la charge Q2 est connectée à la borne négative de la batterie -Vbat. On note que les charges Q1 et Q2 peuvent également être connectées à tout autre potentiel statique.

Ainsi, l'utilisateur de la montre 1 peut détecter avec un appareil de mesure AT, via les signaux Sq1, Sq2 émis, le début et l'arrêt de la génération d'énergie électrique par le générateur thermoélectrique 10.

On notera qu'un signal Sq1 est détectable par un appareil de mesure AT au bout de quelques secondes après que la montre 1 a été placée au poignet ou sur un posage adéquat, une fois que le dispositif d'accumulation d'énergie C5 s'est chargé avec l'énergie électrique produite par le générateur thermoélectrique 10.

On notera que le signal émis Sq2, détectable par l'appareil de mesure AT, apparaît au bout de quelques secondes à quelques minutes, selon les conditions thermiques, après que la montre 1 a été retirée du poignet, durée qui correspond au temps que met le fond de la montre 1 qui a été réchauffé par la chaleur du corps humain à se refroidir.

### ∘ Charge Q

Comme décrit précédemment, la charge Q est configurée pour émettre un signal Sq détectable lorsqu'elle est parcourue par le courant de charge ou décharge i dudit condensateur C1.

Selon le type de charge décrit ci-après, elle sera sensible à une transition montante, à une transition descendante ou aux deux, à savoir elle n'émettra un signal Sq que lors d'une transition montante, que lors d'une transition descendante, ou lors d'une transition montante et d'une transition descendante.

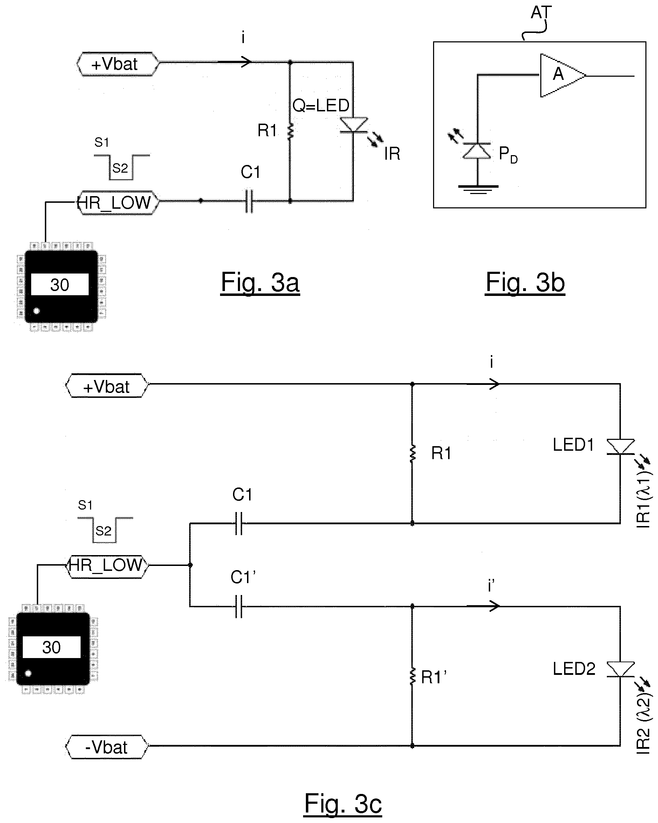

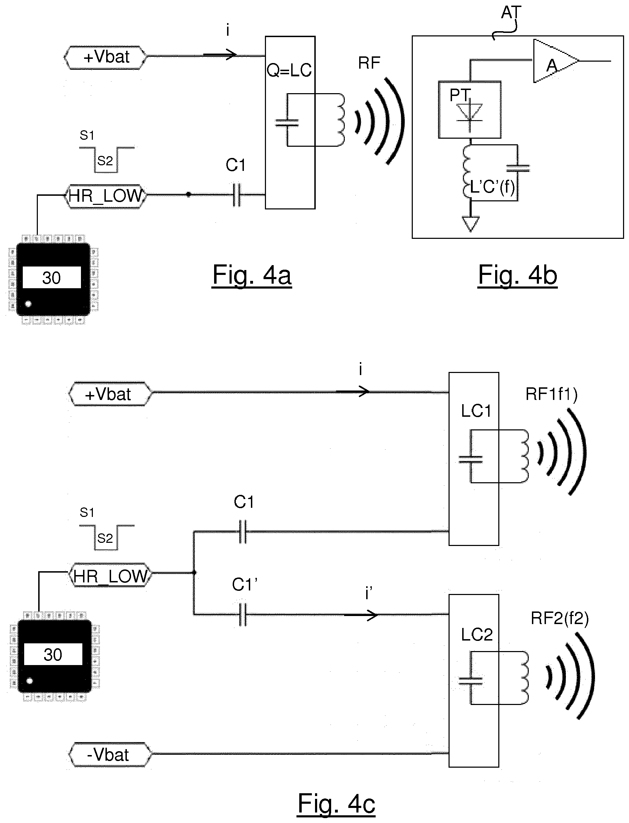

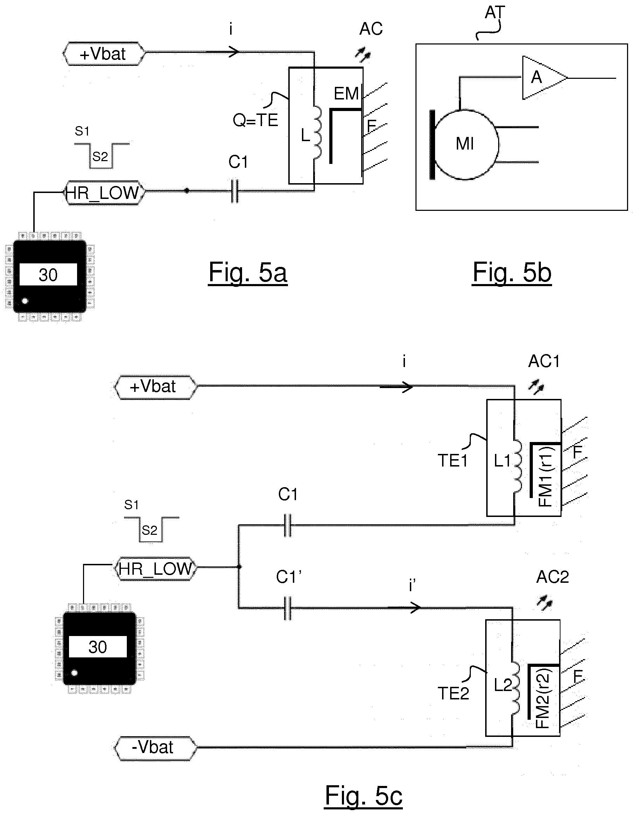

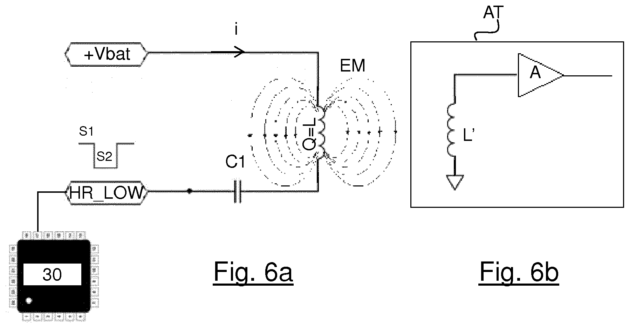

Dans des modes de réalisation non limitatifs, la charge Q est :
- 1) une diode électroluminescente émettant dans le spectre infrarouge (illustrée sur les figures 3a et 3c),
- 2) un circuit oscillant LC bobine/condensateur (illustré sur les figures 4a et 4c), ou RC résistance/condensateur,
- 3) un transducteur électromécanique TE (illustré sur les figures 5a et 5c),
- 4) une bobine L (illustrée sur la figure 6a). De manière duale, la bobine peut être remplacée par un condensateur pour une détection capacitive.

Les différents modes de réalisation de la charge Q sont présentés ci-après.

### 1) Diode électroluminescente LED émettant dans le spectre infrarouge

La diode électroluminescente LED est configurée pour émettre un signal infrarouge IR lorsqu'elle est parcourue par le courant de charge ou décharge i dudit condensateur C1.

De cette manière, l'utilisateur, grâce à un appareil de mesure AT, peut détecter le signal infrarouge IR émis et par conséquent détecter le début ou l'arrêt de la génération d'énergie électrique par le générateur thermoélectrique 10.

Dans un premier mode de réalisation non limitatif illustré sur la figure 3a, le circuit de gestion d'énergie 30 est connecté à un unique condensateur C1 lui-même couplé à une diode électroluminescente LED. La montre 1 ne comprend ainsi qu'une seule diode électroluminescente LED. L'exemple non limitatif de la figure 3a illustre une diode électroluminescente LED qui est une charge Q agencée selon la figure 2a. La diode électroluminescente LED fonctionne grâce à une transition montante ou une transition descendante de la sortie HR_LOW. Au moyen de la diode électroluminescente, on détecte soit le début, soit l'achèvement de la génération d'énergie électrique par le générateur thermoélectrique 10.

Dans un mode de réalisation non limitatif, ledit au moins un condensateur C1 est connecté en série à une résistance R1. La résistance R1 est connectée en parallèle avec ladite au moins une diode électroluminescente LED.

La résistance R1 permet une décharge lente et progressive dudit condensateur C1 après chaque transition montante ou descendante de la sortie HR_LOW, à savoir quand la diode électroluminescente ne conduit plus. On notera que, dans un exemple non limitatif, la résistance R1 conduit le condensateur C1 à se décharger de 90 à 99% en 5 et 10 secondes entre chaque transition. Les constantes de temps RC sont ainsi typiquement situées entre 5 et 10 secondes. Le condensateur C1 se décharge de sorte à obtenir une différence de potentiel nulle à ses bornes.

Dans un mode de réalisation non limitatif illustré sur la figure 3b, l'appareil de mesure AT configuré pour détecter le signal infrarouge IR comprend une photodiode P_{D} et un amplificateur A. Ainsi, lorsque l'appareil de mesure AT se trouve à proximité de la montre 1, il détecte le signal infrarouge IR grâce à un couplage optique qui se créé entre la photodiode P_{D} et la diode infrarouge IR de la montre 1. L'appareil de mesure AT est par exemple un photo-détecteur.

Dans un deuxième mode de réalisation non limitatif illustré sur la figure 3c, le circuit de gestion d'énergie 30 est connecté à deux condensateurs C1, C1' chacun couplé respectivement à une diode électroluminescente LED1, LED2.

La montre 1 comprend ainsi deux diodes électroluminescentes LED1, LED2. L'exemple non limitatif de la figure 3c illustre deux diodes infrarouges LED1, LED2 qui sont respectivement des charges Q1, Q2 agencées selon la figure 2b et fonctionnant selon ce qui a été décrit pour la figure 2b. Grâce aux deux diodes infrarouges LED1, LED2, on détecte le début et également l'achèvement de la génération d'énergie électrique par le générateur thermoélectrique 10.

Les diodes électroluminescentes LED1, LED2 sont configurées pour émettre des signaux infrarouges IR1, IR2 de longueurs d'onde λ1, λ2 différentes.

Dans un mode de réalisation non limitatif, ledit condensateur C1 est connecté à une résistance R1 et ledit condensateur C1' est connecté à une résistance R1'. La résistance R1 est connectée en parallèle avec ladite au moins une diode électroluminescente LED1 et la résistance R1' est connectée en parallèle avec ladite au moins une diode infrarouge LED1'.

La résistance R1 permet une décharge lente et progressive dudit condensateur C1 après chaque transition descendante de la sortie HR_LOW, à savoir quand la diode électroluminescente LED1 ne conduit plus.

La résistance R1' permet une décharge lente et progressive dudit condensateur C1' après chaque transition montante de la sortie HR_LOW, à savoir quand la diode électroluminescente LED2 ne conduit plus.

Dans un mode de réalisation non limitatif non illustré, l'appareil de mesure AT est configuré pour détecter le signal infrarouge IR1 et le signal infrarouge IR2 à l'aide de deux photodiodes P_{D} et deux amplificateurs A, les deux photodiodes P_{D} étant munies de filtres optiques les rendant sensibles aux deux longueurs d'onde λ1, λ2 respectives de sorte à détecter les signaux infrarouges IR1 et IR2 respectifs. Il est techniquement possible de faire une démarche similaire en remplaçant les LED infrarouges, par des LED ultraviolettes, et d'avoir un appareil de mesure sensible aux longueurs d'onde UV, pour autant que les puissances émises soient sans danger.

### 2) Circuit oscillant LC

Le circuit oscillant LC est configuré pour émettre un signal radiofréquence RF lorsqu'il est parcouru par le courant de charge ou décharge i dudit condensateur C1.

De cette manière, l'utilisateur, grâce à un appareil de mesure AT, peut détecter le signal radiofréquence RF émis et par conséquent détecter le début ou l'arrêt de la génération d'énergie électrique par le générateur thermoélectrique 10.

Dans un premier mode de réalisation non limitatif illustré sur la figure 4a, le circuit de gestion d'énergie 30 est connecté à un unique condensateur C1 lui-même couplé à un circuit oscillant LC. La montre 1 ne comprend ainsi qu'un circuit oscillant LC. L'exemple non limitatif de la figure 4a illustre un circuit oscillant LC qui est une charge Q agencée selon la figure 2a. Le circuit oscillant LC génère un signal radiofréquence RF d'une certaine fréquence f lorsqu'il est excité par une impulsion électrique positive ou négative. Il fonctionne donc grâce à une transition montante ou une transition descendante de la sortie HR_LOW. Au moyen du circuit oscillant LC, on détecte soit le début, soit l'achèvement de la génération d'énergie électrique par le générateur thermoélectrique 10.

Dans un mode de réalisation non limitatif illustré sur la figure 4b, l'appareil de mesure AT configuré pour détecter le signal radiofréquence RF comprend un circuit oscillant L'C' accordé à la fréquence f, un pont redresseur PT et un amplificateur A. Ainsi, lorsque l'appareil de mesure AT se trouve à proximité de la montre 1, il détecte le signal radiofréquence RF grâce à un couplage inductif entre son circuit oscillant L'C' et le circuit oscillant LC de la montre 1. Le circuit oscillant L'C' est accordé à la même fréquence que le circuit oscillant LC. Le pont redresseur PT génère une tension continue représentative de l'enveloppe du signal radiofréquence RF, qui est une oscillation amortie à haute fréquence. Dans un mode de réalisation non limitatif, le signal radiofréquence RF se situe dans un domaine de fréquence allant de 100 Hz à 100kHz.

Dans un deuxième mode de réalisation non limitatif illustré sur la figure 5c, le circuit de gestion d'énergie 30 est connecté à deux condensateurs C1, C1' chacun couplé respectivement à un circuit oscillant LC1, LC2.

La montre 1 comprend ainsi deux circuits oscillants LC1, LC2. L'exemple non limitatif de la figure 5c illustre deux circuits oscillants LC1, LC2 qui sont respectivement des charges Q1, Q2 agencées selon la figure 2b et fonctionnant selon ce qui a été décrit pour la figure 2b. Grâce aux deux circuits oscillants LC1 et LC2, on détecte le début et également l'achèvement de la génération d'énergie électrique par le générateur thermoélectrique 10.

Les circuits oscillants LC1, LC2 sont configurés pour émettre des signaux radiofréquence RF1, RF2 de fréquences f1, f2 différentes.

Dans un mode de réalisation non limitatif non illustré, l'appareil de mesure AT configuré pour détecter le signal radiofréquence RF1 et le signal radiofréquence RF2 comprend deux circuits oscillants L'C', deux ponts redresseurs PT et deux amplificateurs A, les deux circuits oscillants L'C' étant accordés aux deux fréquences f1, f2 respectives de sorte à détecter les signaux radiofréquence RF1 et RF2 respectifs. Une variante de ce mode met en oeuvre un oscillateur RC au lieu d'un oscillateur LC.

### 3) Transducteur électromécanique TE

Le transducteur électromécanique TE est configuré pour émettre un signal acoustique AC lorsqu'il est parcouru par le courant de charge ou de décharge i dudit condensateur C1.

De cette manière, l'utilisateur, grâce à un appareil de mesure AT, peut détecter le signal acoustique AC émis et par conséquent détecter le début ou l'arrêt de la génération d'énergie électrique par le générateur thermoélectrique 10.

Dans un premier mode de réalisation non limitatif illustré sur la figure 5a, le circuit de gestion d'énergie 30 est connecté à un unique condensateur C1 lui-même couplé à transducteur électromécanique TE. La montre 1 ne comprend ainsi qu'un transducteur électromécanique TE. L'exemple non limitatif de la figure 5a illustre un transducteur électromécanique TE qui est une charge Q agencée selon la figure 2a. Le transducteur électroacoustique TE fonctionne grâce à une transition montante ou une transition descendante de la sortie HR_LOW. Au moyen du transducteur électromécanique TE, on détecte soit le début, soit l'achèvement de la génération d'énergie électrique par le générateur thermoélectrique 10.

Dans un mode de réalisation non limitatif illustré sur la figure 4a, le transducteur électromécanique TE comprend une bobine L qui coopère avec une lame flexible ferromagnétique FM excitée par la bobine L. Lorsque la bobine L est traversée par le courant i, elle émet un champ électromagnétique. La lame flexible ferromagnétique FM vibre sous l'effet du champ électromagnétique et transmet sa vibration au fond F de la montre 1. Cela génère un signal acoustique AC. La lame flexible ferromagnétique FM peut vibrer à la fréquence de résonnance r. Dans un mode de réalisation non limitatif, le signal acoustique AC se situe dans un domaine de fréquence allant de 100 Hz à 100kHz.

Dans un mode de réalisation non limitatif illustré sur la figure 5b, l'appareil de mesure AT configuré pour détecter le signal acoustique AC comprend un microphone MI et un amplificateur A. Ainsi, lorsque l'appareil de mesure AT se trouve à proximité de la montre 1, il détecte le signal acoustique AC grâce à un couplage acoustique entre le microphone MI et le fond F de la montre 1, le microphone MI détectant la vibration de la lame flexible ferromagnétique FM qui se transmet au fond F de la montre 1.

Dans un deuxième mode de réalisation non limitatif illustré sur la figure 5c, le circuit de gestion d'énergie 30 est connecté à deux condensateurs C1, C1' chacun couplé respectivement à un transducteur électromécanique TE1, TE2.

La montre 1 comprend ainsi deux transducteurs électromécaniques TE1, TE2. L'exemple non limitatif de la figure 5c illustre deux transducteur électromécanique TE1, TE2 qui sont respectivement des charges Q1, Q2 agencées selon la figure 2b et fonctionnant selon ce qui a été décrit pour la figure 2b. Grâce aux deux transducteurs électromécaniques TE1, TE2, on détecte le début et également l'achèvement de la génération d'énergie électrique par le générateur thermoélectrique 10.

Les transducteurs électromécaniques TE1, TE2 sont configurés pour émettre des signaux acoustiques AC1, AC2 à des fréquences de résonnance r1, r2 différentes. A cet effet, ils comprennent chacun une lame flexible ferromagnétique FM1, FM2 de taille différente qui peuvent chacune vibrer à une fréquence de résonnance r1, r2.

Dans un mode de réalisation non limitatif non illustré, l'appareil de mesure AT configuré pour détecter le signal acoustique AC1 et le signal acoustique AC2 comprend deux microphones MI et deux amplificateurs A, les microphones MI étant accordés aux deux fréquences de résonnance r1, r2 respectives de sorte à détecter les signaux acoustiques AC1 et AC2 respectifs. Une variante de ce mode met en œuvre la lame du transducteur électromécanique décrit pour venir taper une contrepièce sous l'effet de l'action de la bobine, et c'est ce choc qui est mesuré par l'appareil de mesure, outre la vibration de la lame.

### 4) Bobine L

La bobine L est configurée pour émettre un champ magnétique EM lorsqu'elle est parcourue par le courant de charge ou de décharge i dudit condensateur C1.

De cette manière, l'utilisateur, grâce à un appareil de mesure AT, peut détecter le champ magnétique EM émis et par conséquent détecter le début ou l'arrêt de la génération d'énergie électrique par le générateur thermoélectrique 10.

L'exemple non limitatif de la figure 6a illustre une bobine L qui est une charge Q agencée selon la figure 2a et fonctionnant selon ce qui a été décrit pour la figure 2a. La bobine L fonctionne grâce à une transition montante et une transition descendante de la sortie HR_LOW. Ainsi, au moyen de la bobine, on détecte le début et l'achèvement de la génération d'énergie électrique par le générateur thermoélectrique 10.

Dans un mode de réalisation non limitatif illustré sur la figure 6b, l'appareil de mesure AT est configuré pour détecter le champ magnétique EM à l'aide d'une bobine L'. Ainsi, lorsque l'appareil de mesure AT se trouve à proximité de la montre 1, il détecte le signal électromagnétique EM grâce à un couplage magnétique entre sa bobine L' et la bobine L de la montre 1. La polarité de la tension induite étant sensible à la polarité de la dérivée du champ magnétique émis, il est possible de distinguer le début et l'achèvement de la génération d'énergie électrique par le générateur thermoélectrique 10, avec un seul canal de transmission et détection, à savoir avec une unique et même bobine L. On peut de manière duale remplacer le courant et la bobine L, par une tension et un condensateur, et détecter la charge électrique du condensateur avec l'appareil de mesure adéquat.

On notera que l'amplificateur A compris dans les différents appareils de mesure AT décrits dans les cas de la charge Q 1) à 4) permet d'amplifier les différents signaux Sq détectés.

Ainsi, les appareils de mesure AT adaptés aux différentes charges Q permettent de détecter l'activité du générateur thermoélectrique 10. La montre 1 peut donc être testée en production, une fois la montre assemblée. La montre 1 peut également être testée en service après-vente. Les différentes charges Q ainsi que les appareils de mesure AT associés décrits ont un coût limité. Par conséquent, la détection est simple à réaliser et est de coût limité.

### • Troisième mode de réalisation non limitatif

Tel qu'illustré sur la figure 7, la montre thermoélectrique 1 comprend :
- un générateur thermoélectrique 10,
- un élévateur de tension 20,
- un circuit de gestion d'énergie 30,
- au moins un condensateur C1.

La montre thermoélectrique 1 comprend en outre :
- un élément de stockage d'énergie 40,
- un moteur 50 configuré pour mettre en mouvement les aiguilles et cadran(s) (non illustrés) de la montre thermoélectrique 1,
- un résonateur 60 configuré pour servir de base de fréquence pour la montre thermoélectrique 1.

La description de ces éléments en référence au premier et au deuxième mode de réalisation est à appliquer dans ce troisième mode de réalisation non limitatif.

Tel qu'illustré sur la figure 7, la montre thermoélectrique 1 comprend en outre un élément conducteur F.

Le condensateur C1 et l'élément conducteur F sont décrits ci-après.

### ∘ Condensateur C1

Tel qu'illustré sur la figure 7, le condensateur C1 est relié électriquement à l'élément conducteur F, lui-même connecté à l'impédance d'entrée Z de l'appareil de mesure AT.

Ainsi, le condensateur C1 est relié par une de ses bornes au circuit de gestion d'énergie 30 et par l'autre de ses bornes à l'élément conducteur F.

Dans un mode de réalisation non limitatif, le condensateur C1 est configuré pour se charger lorsque ladite sortie HR_LOW dudit circuit de gestion d'énergie 30 passe de l'état haut S1 à l'état bas S2 et inversement.

Dans une variante non limitative, le condensateur C1 est configuré pour :
- se charger lorsque ladite sortie HR_LOW dudit circuit de gestion d'énergie 30 passe de l'état haut S1 à l'état bas S2, à savoir lorsque ladite sortie HR_LOW est en transition descendante. Cela correspond à un début de génération d'énergie électrique par le générateur thermoélectrique 10 (ce dernier devient actif),
- se charger également lorsque ladite sortie HR_LOW dudit circuit de gestion d'énergie 30 passe de l'état bas S2 à l'état haut S1, à savoir lorsque ladite sortie HR_LOW est en transition montante. Cela correspond à un achèvement de génération d'énergie électrique par le générateur thermoélectrique 10 (ce dernier devient inactif).

Dans un exemple, le générateur thermoélectrique 10 devient actif lorsque la montre 1 est mise sur le poignet de l'utilisateur et devient inactif lorsque la montre 1 n'est plus portée sur le poignet de l'utilisateur.

Dans un autre exemple, le générateur thermoélectrique 10 devient inactif lorsque la montre 1 se trouve en plein soleil avec un cadran foncé qui absorbe l'énergie du soleil. Même si elle reste sur le poignet, la carrure de la montre 1 devient plus chaude que le poignet. Le générateur thermoélectrique 10 peut s'arrêter plusieurs fois dans la journée. On estime qu'il peut s'arrêter et redevenir actif au maximum une centaine de fois par jour.

### ∘ Elément conducteur F

Dans un mode de réalisation non limitatif, l'élément conducteur F est le fond de la montre 1. Le fond F de la montre 1 est facilement accessible, un appareil de mesure AT peut ainsi facilement coopérer avec le fond F de la montre 1.

Dans un mode de réalisation non limitatif, l'élément conducteur F est en aluminium oxydé.

Dans un mode de réalisation non limitatif, l'élément conducteur F est isolé thermiquement. Cela permet à un flux de chaleur venant du poignet d'être majoritairement canalisé vers le générateur thermoélectrique 10 pour permettre une bonne génération d'énergie électrique par la montre 1. L'isolation thermique se fait au moyen d'un isolant thermique I. Dans le cas du fond F de la montre 1, dans un mode de réalisation non limitatif, l'isolant thermique I est un anneau en plastique qui entoure ledit fond F.

Dans un mode de réalisation non limitatif, l'élément conducteur F est également isolé électriquement de la carrure K de la montre 1 au moyen de l'isolant thermique I. Cela permet d'éviter un court-circuit avec la carrure K de la montre 1. Ainsi l'élément conducteur F est électriquement flottant de sorte qu'il peut servir d'électrode de contact pour l'appareil de mesure AT. Ainsi, le fond F de la montre 1 est utilisé comme une borne de mesure.

Grâce à cette électrode de contact, les charges électriques vont pouvoir être transférées de l'élément conducteur F à l'appareil AT.

Tel qu'illustré sur la figure 8, l'élément conducteur F est en contact avec l'appareil de mesure AT. L'appareil de mesure AT possède une impédance d'entrée Z, un amplificateur A, une pointe de mesure P1 et une pointe de masse M1. L'impédance Z a une valeur élevée qui permet de mesurer une impulsion de tension correspondant au transfert d'une petite quantité de charges électriques.

Le fond F de la montre 1 permet ainsi de transférer des charges électriques par couplage capacitif avec l'appareil de mesure AT. Les charges électriques vont en effet se déplacer dans le fond F de la montre 1, le fond F agissant alors comme un condensateur. Ainsi, lors d'une transition descendante correspondant au début de la génération d'énergie électrique par le générateur thermoélectrique 10, et lors d'une transition montante correspondant à l'achèvement de la génération d'énergie électrique par le générateur thermoélectrique 10, des charges électriques sont transférées du condensateur C1 au fond F puis du fond f à l'appareil de mesure AT.

La pointe de mesure P1 est en contact avec le fond F de la montre 1 et permet le transfert de charges électriques. La pointe de masse M1 permet de mettre à la masse la carrure K de la montre 1. Le courant de charge i du condensateur C1 peut ainsi circuler dans un circuit fermé qui comprend le fond F, l'impédance Z et la carrure K.

Ainsi, l'appareil de mesure AT couplé au fond F permet de détecter l'activité du générateur thermoélectrique 10. La montre 1 peut donc être testée en production, une fois la montre assemblée. La montre 1 peut également être testée en service après-vente. Le condensateur C1 ainsi que l'appareil de mesure AT associé décrit ont un coût limité. Par conséquent, la détection est simple à réaliser et est de coût limité.

Bien entendu, la présente invention ne se limite pas aux exemples illustrés mais est susceptible de diverses variantes et modifications qui apparaîtront à l'homme du métier.

Ainsi, dans un autre mode de réalisation non limitatif, les diverses charges Q peuvent généralement être connectées à tout potentiel statique autre que +Vbat et -Vbat.

## Revendications

1. Montre thermoélectrique (1) comprenant :
- un générateur thermoélectrique (10),
- un élévateur de tension (20) connecté audit générateur thermoélectrique (10),
- un circuit de gestion d'énergie (30) connecté audit élévateur de tension (20) et configuré pour gérer la charge d'au moins un élément de stockage d'énergie (40), ledit circuit de gestion d'énergie (30) comprenant une sortie (HR_LOW) configurée pour passer d'un premier état logique (S1) à un deuxième état logique (S2) lorsque ledit générateur thermoélectrique (10) débute une génération d'énergie électrique, et pour passer du deuxième état logique (S2) au premier état logique (S1) lorsque ledit générateur thermoélectrique (10) achève la génération d'énergie électrique,
**caractérisée en ce qu'**elle comprend en outre au moins un condensateur (C1) connecté audit circuit de gestion d'énergie (30), couplé à une charge (Q) et configuré pour :
- subir une variation de charge (dQ) lorsque ladite sortie (HR_LOW) dudit circuit de gestion d'énergie (30) passe soit du premier état logique (S1) au deuxième état logique (S2), soit du deuxième état logique (S2) au premier état logique (S1),
- alimenter en courant ladite charge (Q) lorsqu'il subit ladite variation de charge (dQ), ladite charge (Q) étant configurée pour émettre un signal (Sq) détectable par un appareil de mesure (AT) lorsqu'elle est parcourue par ledit courant.

2. Montre thermoélectrique (1) selon la revendication précédente, selon laquelle ladite charge (Q) est une diode électroluminescente (LED) configurée pour émettre un signal infrarouge (IR) ou ultraviolet.

3. Montre thermoélectrique (1) selon la revendication 2, selon laquelle une résistance (R1) est branchée en parallèle de la diode électroluminescente (LED).

4. Montre thermoélectrique (1) selon la revendication 1, selon laquelle ladite charge (Q) est un circuit oscillant (LC) configuré pour émettre un signal radiofréquence (RF).

5. Montre thermoélectrique (1) selon la revendication 1, selon laquelle ladite charge (Q) est un transducteur électromécanique (TE) configuré pour émettre un signal acoustique (AC).

6. Montre thermoélectrique (1) selon la revendication 1, selon laquelle ladite charge (Q) est une bobine (L) configurée pour émettre un champ électromagnétique (EM), ou un condensateur configuré pour émettre un champ électrostatique.

7. Montre thermoélectrique (1) selon l'une quelconque des revendications 1 à 5, selon laquelle ladite montre thermoélectrique (1) comprend deux condensateurs (C1, C1') connectés audit circuit de gestion d'énergie (30), chacun couplé à une charge (Q1, Q2),
l'un des condensateurs (C1) étant configuré pour :
- subir une variation de charge (dQ) lorsque ladite sortie (HR_LOW) dudit circuit de gestion d'énergie (30) passe du premier état logique (S1) au deuxième état logique (S2),
- alimenter en courant la charge (Q1) à laquelle il est couplé lorsqu'il subit ladite variation de charge (dQ), ladite charge (Q1) étant configurée pour émettre un signal (Sq) détectable par un appareil de mesure (AT) lorsqu'elle est parcourue par ledit courant (i),
l'autre des condensateurs (C1') étant configuré pour :
- subir une variation de charge (dQ) lorsque ladite sortie (HR_LOW) dudit circuit de gestion d'énergie (30) passe du deuxième état logique (S2) au premier état logique (S1),
- alimenter en courant la charge (Q2) à laquelle il est couplé lorsqu'il subit ladite variation de charge (dQ), ladite charge (Q2) étant configurée pour émettre un signal (Sq') détectable par l'appareil de mesure (AT) lorsqu'elle est parcourue par ledit courant (i').

8. Montre thermoélectrique (1) selon la revendication 7, selon laquelle les charges (Q1, Q2) sont des diodes électroluminescentes (LED1, LED2) configurées pour émettre des signaux infrarouges (IR1, IR2) de longueurs d'onde (λ1, λ2) différentes.

9. Montre thermoélectrique (1) selon la revendication 7, selon laquelle les charges (Q1, Q2) sont des circuits oscillants (LC1, LC2) configurés pour émettre des signaux radiofréquence (RF1, RF2) de fréquences (f1, f2) différentes.

10. Montre thermoélectrique (1) selon la revendication 7, selon laquelle les charges (Q1, Q2) sont des transducteurs électromécaniques (TE1, TE2) configurés pour émettre des signaux électroacoustique (AC1, AC2) de fréquences de résonnance (r1, r2) différentes.

11. Montre thermoélectrique (1) comprenant :
- un générateur thermoélectrique (10),
- un élévateur de tension (20) connecté audit générateur thermoélectrique (10),
- un circuit de gestion d'énergie (30) connecté audit élévateur de tension (20) et configuré pour gérer la charge d'au moins un élément de stockage d'énergie (40), ledit circuit de gestion d'énergie (30) comprenant une sortie (HR_LOW) configurée pour passer d'un premier état logique (S1) à un deuxième état logique (S2) lorsque ledit générateur thermoélectrique (10) débute une génération d'énergie électrique, et pour passer du deuxième état logique (S2) au premier état logique (S1) lorsque ledit générateur thermoélectrique (10) achève la génération d'énergie électrique,
**caractérisée en ce qu'**elle comprend en outre :
- un condensateur (C1) relié audit circuit de gestion d'énergie (30), configuré pour se charger lorsque ladite sortie (HR_LOW) dudit circuit de gestion d'énergie (30) passe du premier état logique (S1) au deuxième état logique (S2) ou inversement ;
- un élément conducteur (F) relié électriquement au condensateur (C1).

12. Montre thermoélectrique (1) selon la revendication 11, selon laquelle ledit élément conducteur (F) est le fond de la montre.

13. Montre thermoélectrique (1) selon l'une quelconque des revendications précédentes, selon laquelle le circuit de gestion (30) comprend un étage amplificateur push-pull.

14. Montre thermoélectrique (1) selon l'une quelconque des revendications précédentes, selon laquelle ledit circuit de gestion d'énergie (30) est configuré pour gérer alternativement la charge de deux éléments de stockage d'énergie (40) de sorte à alimenter un moteur (50) de ladite montre thermoélectrique (1).

## Patentansprüche

1. Thermoelektrische Armbanduhr (1), umfassend:
- einen thermoelektrischen Generator (10),
- eine Spannungserhöhungseinrichtung (20), die mit dem thermoelektrischen Generator (10) verbunden ist,
- eine Energieverwaltungsschaltung (30), die mit der Spannungserhöhungseinrichtung (20) verbunden ist und konfiguriert ist, um die Ladung mindestens eines Energiespeicherelements (40) zu verwalten, wobei die Energieverwaltungsschaltung (30) einen Ausgang (HR_LOW) umfasst, der konfiguriert ist, um von einem ersten logischen Zustand (S1) in einen zweiten logischen Zustand (S2) überzugehen, wenn der thermoelektrische Generator (10) mit einer Generierung von elektrischer Energie beginnt, und um von dem zweiten logischen Zustand (S2) in den ersten logischen Zustand (S1) überzugehen, wenn der thermoelektrische Generator (10) die Generierung von elektrischer Energie beendet,
**dadurch gekennzeichnet, dass** sie weiter mindestens einen Kondensator (C1) umfasst, der mit der Energieverwaltungsschaltung (30) verbunden ist, der mit einer Ladung (Q) gekoppelt ist, und konfiguriert zum:
- Erfahren einer Ladungsvariation (dQ), wenn der Ausgang (HR_LOW) der Energieverwaltungsschaltung (30) entweder von dem ersten logischen Zustand (S1) in den zweiten logischen Zustand (S2) übergeht, oder vom zweiten logischen Zustand (S2) in den ersten logischen Zustand (S1) übergeht,
- Versorgen der Ladung (Q) mit Strom, wenn er die Ladungsvariation (dQ) erfährt, wobei die Ladung (Q) konfiguriert ist, um ein von einem Messgerät (AT) detektierbares Signal (Sq) auszugeben, wenn sie von dem Strom durchlaufen wird.

2. Thermoelektrische Armbanduhr (1) nach dem vorstehenden Anspruch, wobei die Ladung (Q) eine Leuchtdiode (LED) ist, die konfiguriert ist, um ein Infrarot- (IR) oder Ultraviolett-Signal auszugeben.

3. Thermoelektrische Armbanduhr (1) nach Anspruch 2, wobei ein Widerstand (R1) parallel zur Leuchtdiode (LED) angeschlossen ist.

4. Thermoelektrische Armbanduhr (1) nach Anspruch 1, wobei die Ladung (Q) eine oszillierende Schaltung (LC) ist, die konfiguriert ist, um ein Funkfrequenzsignal (RF) auszugeben.

5. Thermoelektrische Armbanduhr (1) nach Anspruch 1, wobei die Ladung (Q) ein elektromechanischer Messgrössenumformer (TE) ist, der konfiguriert ist, um ein akustisches Signal (AC) auszugeben.

6. Thermoelektrische Armbanduhr (1) nach Anspruch 1, wobei die Ladung (Q) eine Spule (L) ist, die konfiguriert ist, um ein Elektromagnetfeld (EM) auszugeben oder ein Kondensator, der konfiguriert ist, um ein elektrostatisches Feld auszugeben.

7. Thermoelektrische Armbanduhr (1) nach einem der Ansprüche 1 bis 5, wobei die thermoelektrische Armbanduhr (1) zwei Kondensatoren (C1, C1') umfasst, die mit der Energieverwaltungsschaltung (30) verbunden sind, jeweils an eine Ladung (Q1, Q2) gekoppelt, wobei der eine der Kondensatoren (C1) konfiguriert ist zum:
- Erfahren einer Ladungsvariation (dQ), wenn der Ausgang (HR_LOW) der Energieverwaltungsschaltung (30) von dem ersten logischen Zustand (S1) in den zweiten logischen Zustand (S2) übergeht,
- Versorgen der Ladung (Q1), mit der er gekoppelt ist, wenn er die Ladungsvariation (dQ) erfährt, mit Strom, wobei die Ladung (Q1) konfiguriert ist, um ein von einem Messgerät (AT) detektierbares Signal (Sq) auszugeben, wenn sie von dem Strom (i) durchlaufen wird,
wobei der andere der Kondensatoren (C1') konfiguriert ist zum:
- Erfahren einer Ladungsvariation (dQ), wenn der Ausgang (HR_LOW) der Energieverwaltungsschaltung (30) von dem zweiten logischen Zustand (S2) in den ersten logischen Zustand (S1) übergeht,
- Versorgen der Ladung (Q2), mit der er gekoppelt ist, wenn der die Ladungsvariation (dQ) erfährt, mit Strom, wobei die Ladung (Q2) konfiguriert ist, um ein von einem Messgerät (AT) detektierbares Signal (Sq') auszugeben, wenn sie von dem Strom (i') durchlaufen wird.

8. Thermoelektrische Armbanduhr (1) nach Anspruch 7, wobei die Ladungen (Q1, Q2) Leuchtdioden (LED1, LED2) sind, die konfiguriert sind, um Infrarotsignale (IR1, IR2) mit unterschiedlichen Wellenlängen (λ1, λ2) auszugeben.

9. Thermoelektrische Armbanduhr (1) nach Anspruch 7, wobei die Ladungen (Q1, Q2) oszillierende Schaltungen (LC1, LC2) sind, die konfiguriert sind, um ein Funkfrequenzsignale (RF1, RF2) mit unterschiedlichen Frequenzen (f1, f2) auszugeben.

10. Thermoelektrische Armbanduhr (1) nach Anspruch 7, wobei die Ladungen (Q1, Q2) elektromechanische Messgrössenumformer (TE1, TE2) sind, die konfiguriert sind, um akustische Signale (AC1, AC2) mit unterschiedlichen Resonanzfrequenzen (r1, r2) auszugeben.

11. Thermoelektrische Armbanduhr (1), umfassend:
- einen thermoelektrischen Generator (10),
- eine Spannungserhöhungseinrichtung (20), die mit dem thermoelektrischen Generator (10) verbunden ist,
- eine Energieverwaltungsschaltung (30), die mit der Spannungserhöhungseinrichtung (20) verbunden ist und konfiguriert ist, um die Ladung mindestens eines Energiespeicherelements (40) zu verwalten, wobei die Energieverwaltungsschaltung (30) einen Ausgang (HR_LOW) umfasst, der konfiguriert ist, um von einem ersten logischen Zustand (S1) in einen zweiten logischen Zustand (S2) überzugehen, wenn der thermoelektrische Generator (10) mit einer Generierung von elektrischer Energie beginnt, und um von dem zweiten logischen Zustand (S2) in den ersten logischen Zustand (S1) überzugehen, wenn der thermoelektrische Generator (10) die Generierung von elektrischer Energie beendet,
**dadurch gekennzeichnet, dass** sie weiter umfasst:
- einen Kondensator (C1), der an die Energieverwaltungsschaltung (30) angeschlossen ist, der konfiguriert ist, um sich aufzuladen, wenn der Ausgang (HR_LOW) der Energieverwaltungsschaltung (30) von dem ersten logischen Zustand (S1) in den zweiten logischen Zustand (S2) übergeht, oder umgekehrt;
- ein Leiterelement (F), das elektrisch an den Kondensator (C1) angeschlossen ist.

12. Thermoelektrische Armbanduhr (1) nach Anspruch 11, wobei das Leiterelement (F) der Boden der Armbanduhr ist.

13. Thermoelektrische Armbanduhr (1) nach einem der vorstehenden Ansprüche, wobei die Verwaltungsschaltung (30) eine Push-Pull-Verstärkerstufe umfasst.

14. Thermoelektrische Armbanduhr (1) nach einem der vorstehenden Ansprüche, wobei die Energieverwaltungsschaltung (30) konfiguriert ist, um abwechselnd die Ladung von zwei Energiespeicherelementen (40) zu verwalten, um einen Motor (50) der thermoelektrischen Armbanduhr (1) zu versorgen.

## Claims

1. Thermoelectric watch (1) comprising:
- a thermoelectric generator (10),
- a voltage booster (20) connected to said thermoelectric generator (10);
- an energy management circuit (30) connected to said voltage booster (20) and configured to control the charging of at least one energy storage element (40), said energy management circuit (30) including an output (HR_LOW) configured to change from a first logic state (S1) to a second logic state (S2) when said thermoelectric generator (10) starts generating electrical energy, and to change from the second logic state (S2) to the first logic state (S1) when said thermoelectric generator (10) finishes generating electrical energy,
**characterized in that** the watch further includes at least one capacitor (C1) connected to said energy management circuit (30), coupled to a load (Q) configured to:
- undergo a variation of load (dQ) when said output (HR_LOW) of said energy management circuit (30) changes either from the first state (S1) to the second state (S2), or from the second state (S2) to the first state (S1),
- supply current to said load (Q) when said capacitor undergoes said variation of load (dQ), said load (Q) being configured to emit a signal (Sq) detectable by a measuring apparatus (AT) when said current flows therethrough.

2. Thermoelectric watch (1) according to the preceding claim, wherein said load (Q) is a light emitting diode (LED) configured to emit an infrared (IR) or ultraviolet signal.

3. Thermoelectric watch (1) according to claim 2, wherein a resistor (R1) is connected in parallel to the light emitting diode (LED).

4. Thermoelectric watch (1) according to claim 1, wherein said load (Q) is an an oscillating circuit (LC) configured to emit a radiofrequency signal (RF).

5. Thermoelectric watch (1) according to claim 1, wherein said load (Q) is an electromechanical transducer (TE) configured to emit an acoustic (AC) signal.

6. Thermoelectric watch (1) according to claim 1, wherein said load (Q) is a coil (L) configured to emit an electromagnetic field (EM), or a capacitor configured to emit an electrostatic field.

7. Thermoelectric watch (1) according to any of claims 1 to 5, wherein said thermoelectric watch (1) includes two capacitors (C1, C1') connected to said energy management circuit (30), each coupled to a load (Q1, Q2),
one of the capacitors (C1) being configured to:
- undergo a variation of load (dQ) when said output (HR_LOW) of said energy management circuit (30) changes from the first logic state (S1) to the second logic state (S2),
- supply current to the load (Q1) to which said capacitor is coupled when it undergoes said variation of load (dQ), said load (Q1) being configured to emit a signal (Sq) detectable by a measuring apparatus (AT) when said current (i) flows therethrough,
the other capacitor (C1') being configured to:
- undergo a variation of load (dQ) when said output (HR_LOW) of said energy management circuit (30) changes from the second logic state (S2) to the first logic state (S1),
- supply current to the load (Q2) to which said capacitor is coupled when it undergoes said variation of load (dQ), said load (Q2) being configured to emit a signal (Sq') detectable by the measuring apparatus (AT) when said current (i') flows therethrough.

8. Thermoelectric watch (1) according to claim 7, wherein the loads (Q1, Q2) are light emitting diodes (LED1, LED2) configured to emit infrared signals (IR1, IR2) on different wavelengths (λ1, λ2).

9. Thermoelectric watch (1) according to claim 7, wherein the loads (Q1, Q2) are oscillating circuits (LC1, LC2) configured to emit radiofrequency signals (RF1, RF2) of different frequencies (f1, f2).

10. Thermoelectric watch (1) according to claim 7, wherein the loads (Q1, Q2) are electromechanical transducers (TE1, TE2) configured to emit electroacoustic signals (AC1, AC2) of different resonance frequencies (r1, r2).

11. Thermoelectric watch (1) comprising:
- a thermoelectric generator (10),
- a voltage booster (20) connected to said thermoelectric generator (10);
- an energy management circuit (30) connected to said voltage booster (20) and configured to control the charging of at least one energy storage element (40), said energy management circuit (30) including an output (HR_LOW) configured to change from a first logic state (S1) to a second logic state (S2) when said thermoelectric generator (10) starts generating electrical energy, and to change from the second logic state (S2) to the first logic state (S1) when said thermoelectric generator (10) finishes generating electrical energy,
**characterized in that** the watch further includes:
- a capacitor (C1) connected to said energy management circuit (30), configured to charge when said output (HR_LOW) of said energy management circuit (30) changes from the first logic state (S1) to the second logic state (S2) or vice versa;
- a conductive element (F) electrically connected to the capacitor (C1).

12. Thermoelectric watch (1) according to claim 11, wherein said conductive element (F) is the back cover of the watch.

13. Thermoelectric watch (1) according to any of the preceding claims, wherein the management circuit (30) includes a push-pull amplifier stage.

14. Thermoelectric watch (1) according to any of the preceding claims, wherein said energy management circuit (30) is configured to alternately control the charging of two energy storage elements (40) in order to power a motor (50) of said thermoelectric watch (1).
